# EUROPÄISCHE PATENTSCHRIFT

(11) **EP 2 986 090 B1**
(45) Veröffentlichungstag und Bekanntmachung des Hinweises auf die Patenterteilung: **27.09.2017**
(21) Anmeldenummer: 14002809.3
(22) Anmeldetag: 12.08.2014
(51) Int. Cl.: H05K 5/00, B26B 19/38, B65D 6/00, B65D 43/02, B65D 43/16, B65D 45/20, E05D 1/06, H02B 1/46, H05K 5/02

(54) **Gehäuse mit einem Unterteil und einem Oberteil**
Housing with a bottom section and a top section
Boîtier avec une partie inférieure et une partie supérieure

(43) Veröffentlichungstag der Anmeldung: 17.02.2016
(73) Patentinhaber: bopla Gehäuse Systeme GmbH, 32257 Bünde (DE)
(72) Erfinder: Krömer, Andreas, 32425 Minden (DE)
(74) Vertreter: Weeg, Thomas

(56) Entgegenhaltungen:
- EP-A1- 0 401 085
- DE-B3-102011 116 696
- DE-C1- 4 405 947
- FR-A- 1 408 204
- US-A1- 2004 094 318

## Beschreibung

Die vorliegende Erfindung bezieht sich auf ein Gehäuse mit einem Unterteil und einem Oberteil nach dem Oberbegriff des Anspruchs 1.

Aus dem Stand der Technik sind verschiedene Möglichkeiten bekannt, das Oberteil und das Unterteil eines Gehäuses miteinander zu verbinden. So sind in der Schrift EP 0 401 085 A1 Bandscharniere mit endseitigen Fußteilen offenbart, die zwar von außen unsichtbar sind, jedoch eine Mehrzahl von vergleichsweise großen Kanälen im Gehäuse benötigen, in denen diese geführt und mit Endanschlägen blockiert sind. Die Montage und endseitige Blockierung solcher Fußteile ist aufwendig. Aus der Schrift DE 20 2004 012 462 U1 ist ein Gehäuse bekannt, auf das endseitig Deckel aufgesetzt und mit dem Gehäuse verschraubt werden können. Die Verschraubung der Deckel ist deutlich sichtbar.

Ein gattungsgemäßes Gehäuse ist auch aus der Schrift US 2004/0094318 bekannt. Das Oberteil ist zwar über ein Scharnier mit dem Unterteil verbunden, das Scharnier liegt allerdings offen, kann leicht verschmutzen und steht über die Außenwand hervor. Da die Außenscharnierteile nur auf die Scharnierwelle aufgesteckt sind, ist die Scharnierverbindung schwach und wenig belastbar.

Aus der Schrift DE 44 05 947 C1 ist ein spannbares Scharnier zur Verbindung eines Oberteils mit einem Unterteil bekannt, das wegen seiner vielen beweglich miteinander verbundenen Teile allerdings einen großen Bauaufwand verursacht und die Verbindungstechnik nach außen sichtbar macht. Die Schrift DE 10 2011 116 696 B3 zeigt ebenfalls ein Gehäuse mit einem spannbaren Scharnier, das optisch wenig ansprechend ist und bei dem das Scharnier seitlich weit über die Seitenwände des Gehäuses hervorsteht.

Demgemäß ist es die Aufgabe der vorliegenden Erfindung, eine Verbindungsmöglichkeit zur Verbindung des Oberteils mit dem Unterteil zu schaffen, die wenig Bauraum beansprucht, optisch ansprechend ist und wenig Montageaufwand verursacht.

Die Aufgabe wird für ein gattungsgemäßes Gehäuse mit den kennzeichnenden Merkmalen des Anspruchs 1 gelöst.

Die Verbindung des Oberteils mit einem Verbindungsprofil über nach außen hervorstehende Laschen schafft eine gute Befestigungsmöglichkeit für das Verbindungsprofil. Durch die Ausbildung der Schraublöcher bzw. der Einschraubmöglichkeit an den passenden Stellen in der oder den Laschen und dem Verbindungsprofil können die Bauteile auf einfache Weise lösbar miteinander verbunden werden. Bei der der Verschraubung dienenden Einschraubmöglichkeit kann es sich ebenfalls um ein Schraubloch handeln, oder es sind Dübel oder andere Vorrichtungen zur Verschraubung vorgesehen. Das Verbindungsprofil kann in seiner äußeren Form ansprechend gestaltet sein, da die Befestigungsfunktion auf der in der Befestigungsposition nicht sichtbaren Innenseite des Verbindungsprofils ausgebildet sein kann. Das Schraubloch in der oder den Laschen hat eine genau vertikale oder zumindest annähernd vertikale Ausrichtung, so dass eine Schraubmöglichkeit an der Seitenwand des Gehäuses entlang beziehungsweise von oben oder unten gegeben ist.

Das Verbindungsprofil umgreift in seiner Montageposition die am Oberteil ausgebildete Lasche oder die dort ausgebildeten Laschen von außen und oben und weist im nach außen weisenden Bereich der der Verschraubung dienenden Einschraubmöglichkeit eine geschlossene Oberfläche auf, so dass die in das profilseitige Schraubloch eingeschraubte Schraube von unten in das Schraubloch eingeschraubt ist. Bei dieser Ausbildung sind die Schraublöcher oder die Einschraubmöglichkeit von außen und oben nicht sichtbar, da die Oberfläche des Verbindungsprofils im entsprechenden nach oben und zur Seite weisenden Bereich geschlossen ausgebildet und die Schraube nur aus einer Blickrichtung von unten nach oben sichtbar ist.

Das Verbindungsprofil ist aus zwei Profilteilen zusammengesetzt, die durch ein Scharnier miteinander verbunden sind. Das Scharnier eröffnet die Möglichkeit, den Deckel auf- und zuschwenken zu können, ohne dafür den Deckel komplett lösen zu müssen. Die Scharnierfunktion kann auch oder alternativ dazu genutzt werden, das Verbindungsprofil als verschwenkbare Klemmlasche auszubilden, so dass das Verbindungsprofil mit dem Unterteil verklemmt wird und nicht notwendigerweise verschraubt werden muss.

Nach einer Ausgestaltung der Erfindung sind an dem Oberteil und/oder dem Unterteil im Bereich des Verbindungsprofils seitlich Vorsprünge ausgebildet, die das Scharnier in der Einbaulage seitlich abdecken. Durch die seitliche Abdeckung des Scharniers kann nicht so leicht Schmutz in den Scharnierbereich dringen. Die Optik des Gehäuses ist gefälliger, wenn das Scharnier nicht sichtbar ist. Durch die Vorsprünge wird das empfindliche Scharnier besser gegen seitliche Stöße und Beschädigungen geschützt. Zudem können die beiden Schenkel des Verbindungsprofils, die das Scharnier ausbilden, durch die seitlichen Vorsprünge gegen ein Verschieben relativ zueinander blockiert werden, so dass beide Schenkel des Verbindungsprofils auch durch die Vorsprünge in ihrer Einbaulage gehalten werden. Dadurch wird das Gehäuse insgesamt stabilisiert.

Nach einer Ausgestaltung der Erfindung sind an dem Unterteil auf zumindest einer Seite eine oder mehrere über eine benachbarte Seitenwand nach außen hervorstehende Laschen angeformt, die jeweils zumindest ein Schraubloch aufweisen, und das Unterteil ist über das Schraubloch mit einem Verbindungsprofil verschraubt, das an einer dem laschenseitigen Schraubloch entsprechenden Position ebenfalls eine der Verschraubung dienende Einschraubmöglichkeit aufweist. Für die am Unterteil ausgebildete Lasche oder Laschen gelten die vorstehenden Ausführungen zu der oder den am Oberteil ausgeführten Laschen entsprechend. Auch hier hat das Schraubloch in der oder den Laschen eine genau vertikale oder zumindest annähernd vertikale Ausrichtung, so dass eine Schraubmöglichkeit an der Seitenwand des Gehäuses entlang beziehungsweise von oben oder unten gegeben ist.

Nach einer Ausgestaltung der Erfindung umgreift das Verbindungsprofil in seiner Montageposition die am Unterteil ausgebildete Lasche oder die dort ausgebildeten Laschen von außen und unten und weist im nach außen weisenden Bereich der der Verschraubung dienenden Einschraubmöglichkeit eine geschlossene Oberfläche auf, so dass die in das profilseitige Schraubloch eingeschraubte Schraube von oben in das Schraubloch eingeschraubt ist. Auch hier gelten die vorstehenden Ausführungen für das mit dem Oberteil verbundene Verbindungsprofil entsprechend.

Nach einer Ausgestaltung der Erfindung ist das Verbindungsprofil auf einer Seite des Gehäuses mit einem Scharnier oder einem Schwenkgelenk zur Verschwenkung des Oberteils gegenüber dem Unterteil und das Verbindungsprofil auf der gegenüberliegenden Seite des Gehäuses als ein Riegelprofil ausgebildet, das einen über ein Scharnier oder ein Schwenkgelenk verschwenkbares Riegelteil aufweist. Durch diese Kombination der Verbindungsprofile kann das Oberteil mit dem Unterteil fest, aber lösbar verbunden werden, und es ist ein Aufklappen des Gehäuses möglich, indem das Riegelprofil geöffnet wird. Dabei sind alle beweglichen Teile unverlierbar, da die Verbindungsprofile fest mit dem Ober- und Unterteil verschraubt sind. Das Riegelteil kann als Riegel ausgebildet sein, und/oder es ist ein Klemmteil, das nur an einem anderen Bauteil verklemmt wird, um in seiner Schließposition fixiert zu sein.

Nach einer Ausgestaltung der Erfindung weist das Riegelteil auf seiner dem Gehäuse zugewandten Innenseite eine Rastnase auf, mit der das Verbindungsprofil in einer Schließstellung verrastbar ist. Durch die Rastnase wird das Riegelteil in seiner Schließstellung eingerastet gehalten, so dass es sich nicht ohne eine besondere Öffnungskraft aus seiner Schließstellung lösen kann. Bevorzugt ist die Rastnase auf der nicht sichtbaren Innenseite des Verbindungsprofils ausgebildet, so dass die äußere Optik des Gehäuses durch die Rastnase nicht gestört wird.

Nach einer Ausgestaltung der Erfindung weist das Riegelteil an seinem Ende eine Grifflasche oder eine andere Ausgestaltungsform zum Öffnen auf. Durch die Grifflasche wird das Öffnen und Schließen des Riegelteils erleichtert. Anstelle einer Grifflasche können auch andere Ausgestaltungsformen verwendet werden, wie Griffmulden, Noppen und dergleichen.

Nach einer Ausgestaltung der Erfindung ist auf der der Lasche oder den Laschen gegenüberliegenden Seite des Oberteils und/oder des Unterteils ein Widerlager zur Verbindung mit dem Verbindungsprofil ausgebildet. Durch ein Widerlager kann das Verbindungsprofil insbesondere in seiner Schließstellung abgestützt und in einer Solllage positioniert sein. Das Widerlager kann eine Form aufweisen, die formschlüssig zur Kontaktfläche des daran anliegenden Abschnitts des Verbindungsprofils ausgebildet ist. Das Widerlager kann für die feste Verriegelung und/oder Verklemmung des Verbindungsprofils mit dem Ober- oder Unterteil genutzt werden.

Nach einer Ausgestaltung der Erfindung sind das Oberteil, das Unterteil und die Verbindungsprofile aus einem Metall hergestellt. Als Metall kann beispielsweise Aluminium oder eine Aluminiumlegierung verarbeitet sein. Gegenüber Kunststoffgehäusen verfügen metallische Gehäuse über eine größere Festigkeit und Formbeständigkeit, wobei durch die Ausbildung auch der Verbindungsprofile als metallische Bauteile die Vorteile dieses Werkstoffs auch bei der Verbindungstechnik bestehen bleiben. Die Temperaturfestigkeit, Alterungsbeständigkeit des Materials, die Lackierbarkeit, UV-Beständigkeit und andere Vorteile gelten also auch für die Verbindungstechnik.

Nach einer Ausgestaltung der Erfindung ist die der Verschraubung dienende Einschraubmöglichkeit als eine sich in Längsrichtung des Verbindungsprofils erstreckende Nut ausgebildet, deren Kanalweite ein Untermaß zum Durchmesser der eingesetzten Schraube im Gewindebereich aufweist. Die Nut kann auch als ein Gewindekanal ausgeführt sein, der beispielsweise bei der Profilherstellung direkt in das Profil eingepresst wird. Bei der Ausbildung der Verschraubungsmöglichkeit als Nut anstelle eines Schraubloches muss das Verbindungsprofil bei seiner Montage nicht millimetergenau und genau zentrisch über dem Schraubloch einer Lasche ausgerichtet sein, zumindest in Längsrichtung der Nut ermöglicht diese Ausgestaltung mehr Freiheitsgrade bei der Montage. Die Querausrichtung des Verbindungsprofils zum Ober- und/oder Unterteil kann besser auf ein gleichmäßiges Fugenbild ausgerichtet sein. Vor allen Dingen ist es aber bei einer Ausbildung der Einschraubmöglichkeit als durchlaufende Nut möglich, als Verbindungsprofil Endlos-Stangenware zu verwenden, die kostengünstig herstellbar ist. Bei Endlos-Stangenware kann ein Verbindungsprofil bei der Montage in einer gewünschten Länge von der Stange abgelängt werden. Daraus ergeben sich logistische und kostenmäßige Vorteile. Es ist nicht erforderlich, zur Herstellung verschieden großer Gehäuse jeweils ein Werkzeug für die Verbindungsprofile mit einer entsprechenden Länge vorzuhalten. Durch das Untermaß der Kanalweite der Nut hat eine selbstschneidende Schraube, die in die Nut eingedreht wird, noch genügend Futter in den Seitenwänden der Nut, um sich für ihren sicheren Halt in diesem Material abzustützen.

Nach einer Ausgestaltung der Erfindung handelt es sich bei den beiden für ein Verbindungsprofil verwendeten Profilteilen um extrudierte, passend abgelängte Profilstücke und die beiden Profilteite sind im Scharnierbereich so gestaltet, dass das erste Profilteil einen Aufnahmeraum mit einer in einem Abschnitt kreisbogenförmig gestalteten Innenoberfläche aufweist, in den das am zweiten Profilteil ausgebildete Scharnierteil eingeschoben ist, wobei das am zweiten Profilteil ausgebildete Scharnierteil eine in einem Abschnitt kreisbogenförmig gestaltete Außenoberfläche aufweist, die spielfrei oder zumindest nahezu spielfrei auf der Innenoberfläche des Aufnahmeraums aufliegt. Durch diese Ausgestaltung der beiden Profilteile ergibt sich ein seitlich geschlossenes Verbindungsprofil, bei dem sich eine zwangsweise geführte Schwenkbewegung des verschwenkten Ober- oder Unterteils über die kreisbogenförmigen Flächen ohne ein Wackeln der Bauteile relativ zueinander ergibt. Dadurch entsteht ein wertiger Qualitätseindruck.

Nach einer Ausgestaltung der Erfindung sind an dem Unterteil und/oder dem Oberteil Laschen in unterschiedlicher Höhenlage ausgebildet. Durch die unterschiedliche Höhenlage der Laschen ist es möglich, das Oberteil und das Unterteil direkt miteinander ohne eine Schwenkmöglichkeit zu verschrauben, wobei bei einer solchen Verschraubung die Laschen vorteilhaft direkt ohne einen Zwischenraum oder mit nur einem kleinen Abstand zueinander aufeinander liegen, oder die Laschen sind so weit voneinander beabstandet, dass zwischen ihnen noch ausreichend Raum übrig bleibt, um darin die Schraubköpfe der verwendeten Schrauben aufnehmen zu können, ohne dass diese bei geschlossenem Gehäuse von außen sichtbar sind und mit anderen Bauteilen kollidieren.

Es wird ausdrücklich hingewiesen, dass die vorstehend beschrienen Ausgestaltungen der Erfindung jeweils für sich, aber auch untereinander mit dem Gegenstand des Anspruchs 1 kombinierbar sind, soweit dem keine technisch zwingenden Hindernisse entgegenstehen.

Weitere Abwandlungen und Ausgestaltungen der Erfindung lassen sich der nachfolgenden gegenständlichen Beschreibung und Zeichnungen entnehmen. Die Erfindung soll nun anhand eines Ausführungsbeispiels näher beschrieben werden. Es zeigen:
- Fig. 1:: eine Ansicht von schräg oben auf ein noch offenes Gehäuse,
- Fig. 2:: eine Querschnittsansicht durch ein geschlossenes Gehäuse,
- Fig. 3:: eine Querschnittsansicht durch das in Fig. 2 gezeigte Gehäuse mit offenem Riegelteil, und
- Fig. 4:: das in den Fig. 2 und 3 gezeigte Gehäuse mit aufgeschwenktem Deckel.

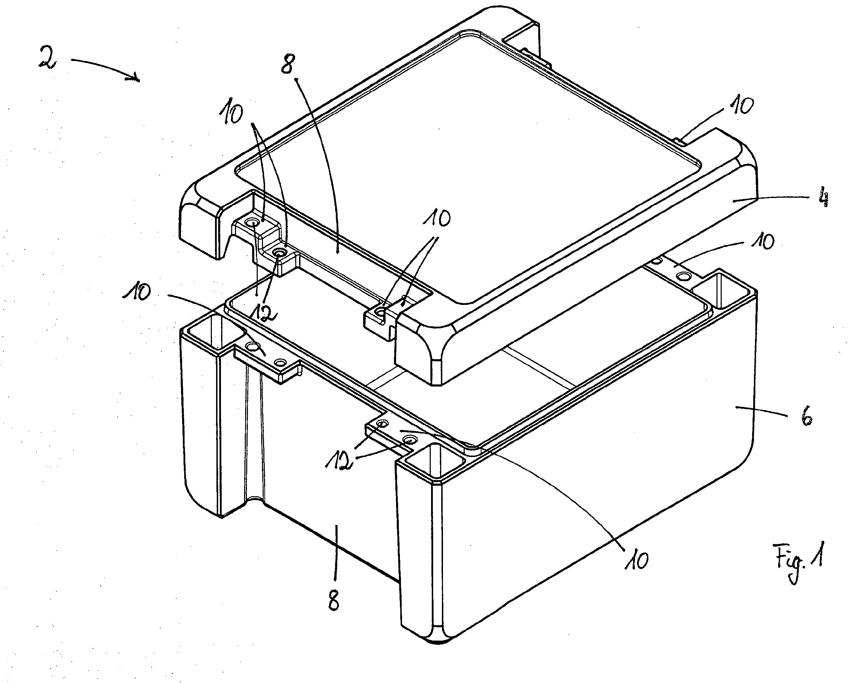

In Fig. 1 ist ein Gehäuse 2 gezeigt, bei dem das Oberteil 4 noch nicht vollständig auf das Unterteil 6 aufgesetzt ist, so dass der Innenraum des Unterteils 6 teilweise sichtbar ist. Im Bereich der stirnseitigen Seitenwände 8 sind am Oberteil 4 und Unterteil 6 an gegenüberliegenden Gehäuseseiten Laschen 10 ausgebildet. In den Laschen 10 befinden sich Schraublöcher 12.

Die am Oberteil 4 ausgebildeten Laschen 10 sind im Ausführungsbeispiel in einer unterschiedlichen Höhenlage ausgebildet. Während die innenliegenden Laschen 10 des Oberteils beim Aufsetzen des Oberteils auf das Unterteil auf die darunter befindlichen Laschen 10 des Unterteils 6 aufsetzen, sind die außenseitigen Laschen 10 am Oberteil 4 höher an der Seitenwand 8 positioniert, so dass beim Aufsetzen des Oberteils 4 auf das Unterteil 6 noch ein freier Zwischenraum zur entsprechenden Lasche 10 am Unterteil verbleibt. In diesem Zwischenraum können Schraubköpfe von Verschraubungen aufgenommen sein.

Die an dem Oberteil 4 und dem Unterteil 6 ausgebildeten Laschen 10 stehen über die benachbarte Seitenwand 8 jeweils hervor. Sie bilden auf diese Art eine Art Auflage für ein in Fig. 1 nicht näher dargestelltes Verbindungsprofil 14.

Während die Schraublöcher 12 in den innenliegenden Laschen 10 an dem Oberteil 4 in der Verschlussstellung des Oberteils 4 auf dem Oberteil 6 konzentrisch sind zu den innenliegenden Schraublöchern in den am Unterteil 6 ausgebildeten Laschen 10, ist dies für die außenliegenden Schraublöcher 12 der Laschen 10 nicht zwingend erforderlich, da diese Schraublöcher nicht der direkten Verschraubung des Oberteils 4 mit dem Unterteil 6 dienen, sondern der Verbindung mit dem Verbindungsprofil 14.

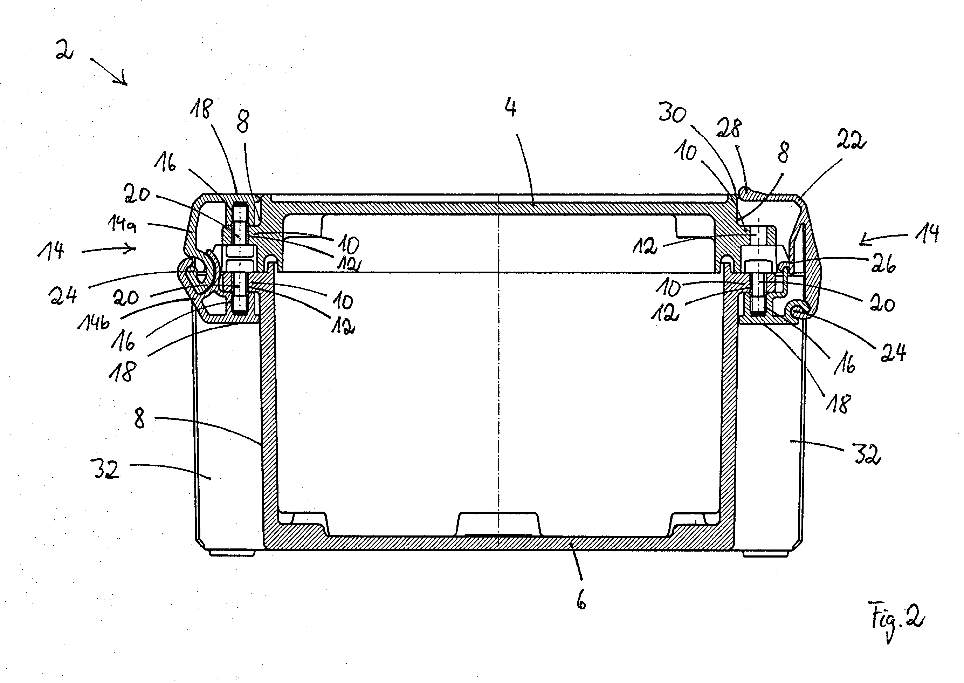

In Fig. 2 ist ein Schnitt durch ein geschlossenes Gehäuse 2 gezeigt, in der auch das Verbindungsprofil 14 in einer Verschlussstellung gezeigt ist. In Fig. 2 liegt das Oberteil auf dem Unterteil 6 auf. In Fig. 2 sind zwei unterschiedliche Verbindungsprofile 14 gezeigt. Auf der linken Seite ist das Verbindungsprofil 14 mit zwei Profilteilen ausgeführt, die über ein Scharnier 24 miteinander verbunden sind. Während das erste Profilteil mit dem Oberteil 4 verschraubt ist, ist das zweite Profilteil mit dem Unterteil 6 verschraubt. Die Verschraubung der Profilteile des Verbindungsprofils 14 erfolgt verbindungsprofilseitig über jeweils eine Einschraubmöglichkeit 16, die als Schraubloch 12, aber auch als eine durchgehende Nut im Verbindungsprofil 14 ausgeführt sein kann, wobei die Nut zum Umfang des Schraubenschaftes im Gewindebereich ein Untermaß aufweist, damit die Schraube 20 in der Einschraubmöglichkeit 16 ausreichend Halt finden kann. Als Alternative können auch Gewindekanäle in den Verbindungsprofilen 14 direkt bei der Profilherstellung eingepresst werden. In der Schnittansicht ist gut erkennbar, dass das Verbindungsprofil 14 im Bereich der beiden Einschraubmöglichkeiten 16 nach außen hin eine geschlossene Oberfläche 18 aufweist, so dass die Verschraubung des Verbindungsprofils 14 mit dem Oberteil 4 und dem Unterteil 6 von außen nicht sichtbar ist, wenn das Gehäuse 2 geschlossen ist.

Auf der rechten Seite ist eine Ausführung eines Verbindungsprofils 14 gezeigt, bei der ein Profilteil des Verbindungsprofils 14 als ein Riegelprofil 22 ausgebildet ist. Das Riegelprofil 22 kann nach Wunsch auf- und zugeschwenkt werden, da es mit dem Oberteil 4 nicht verschraubt ist, sondern nur über das Scharnier 24 und das zweite Profilteil fest mit dem Unterteil 6 verschraubt ist. Auf der Innenseite des Riegelprofils 22 ist eine Rastnase 26 ausgebildet, mit der das Riegelprofil 22 in einer Schließstellung verrastbar ist. Wenn das Riegelprofil 22 aufgeschwenkt werden soll, kann es an einer Grifflasche 28 erfasst und von Hand weggeschwenkt werden. Andere Ausgestaltungsmöglichkeiten, welche ein Öffnen des Riegelprofils 22 ermöglichen, sind hier ebenfalls denkbar. In der Schließstellung ist das Riegelprofil 22 an seinem oberen Ende gegen ein Widerlager 30 angelegt. In der Schließstellung des Riegelprofils 22 sind auch dort keinerlei Schrauben von außen sichtbar.

Die in Fig. 2 sichtbaren Schrauben 20 müssen bei geöffnetem Oberteil 4 in die Schraublöcher 12 und die Einschraubmöglichkeiten 16 eingeschraubt werden. Nach der Verschraubung der drei in Fig. 2 sichtbaren Schrauben 20 kann das Oberteil 4 geschlossen und die auf der rechten Seite befindlichen Laschen 10 mit dem Riegelprofil 22 abgedeckt werden.

In Fig. 2 ist gut erkennbar, dass die Scharniere 24 in seitlicher Richtung jeweils durch einen Vorsprung 32 zur Seite hin abgedeckt sind. Durch die Vorsprünge 32 werden die Profilteile 14a, 14b gegen ein ungewolltes seitliches Verschieben blockiert.

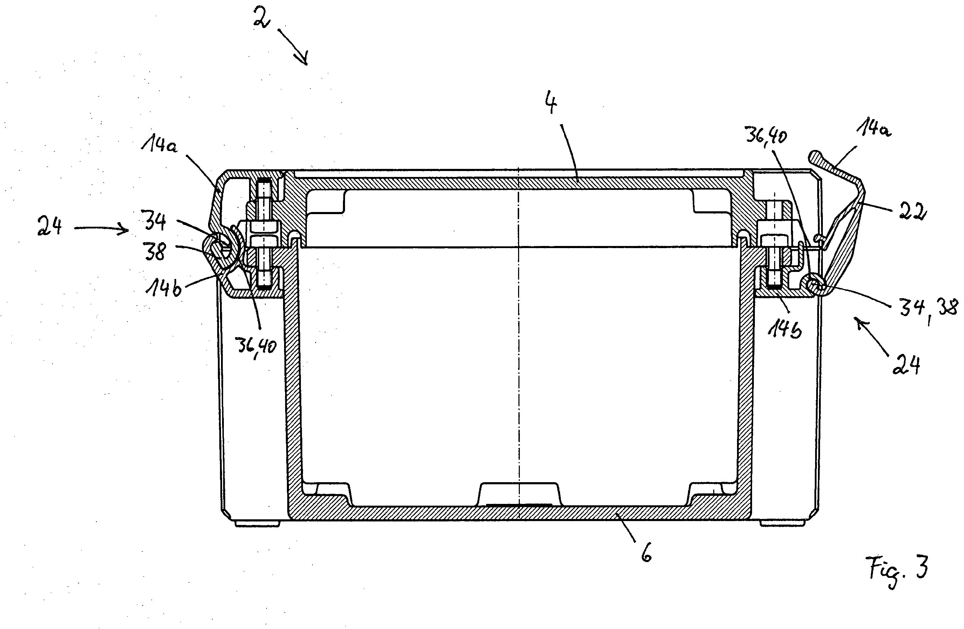

In Fig. 3 ist die in Fig. 2 gezeigte Schnittansicht mit dem Unterschied gezeigt, dass das Riegelprofil 22 aus der Schließstellung in eine Offenstellung bewegt dargestellt ist. In Fig. 3 ist erkennbar, dass die beiden Profilteile 14b im Scharnierbereich einen Aufnahmeraum 34 ausbilden, in den das am Verbindungsprofil 14a als zweites Profilteil ausgebildete Scharnierteil 38 eingeschoben ist. Sowohl die Innenoberfläche 36 des Aufnahmeraums 34 als auch die Außenoberfläche 40 des Scharnierteils 38 sind in einem Abschnitt kreisbogenförmig gestaltet und liegen spielfrei aufeinander auf. Die kreisbogenförmige Gestaltung der zueinander korrespondierenden Oberflächen erlaubt eine Schwenkbewegung des Oberteils 4 zum Unterteil 6, wobei die Schwenkachse dem Mittelpunkt des Kreisbogens entspricht, nachdem die Innenoberfläche 36 und die Außenoberfläche 40 bestimmt sind. Da die Verbindungsprofile 14b durch die Verschraubung mit dem Unterteil 6 lagefixiert sind, ist zunächst nur das Riegelprofil 22 in eine Offenstellung verschwenkbar, und danach kann das Oberteil 4 in eine Offenstellung verschwenkt werden, bei der beim linken Verbindungsprofil 14 das Verbindungsprofil 14a in dem Gelenk 24 um die Schwenkachse dreht.

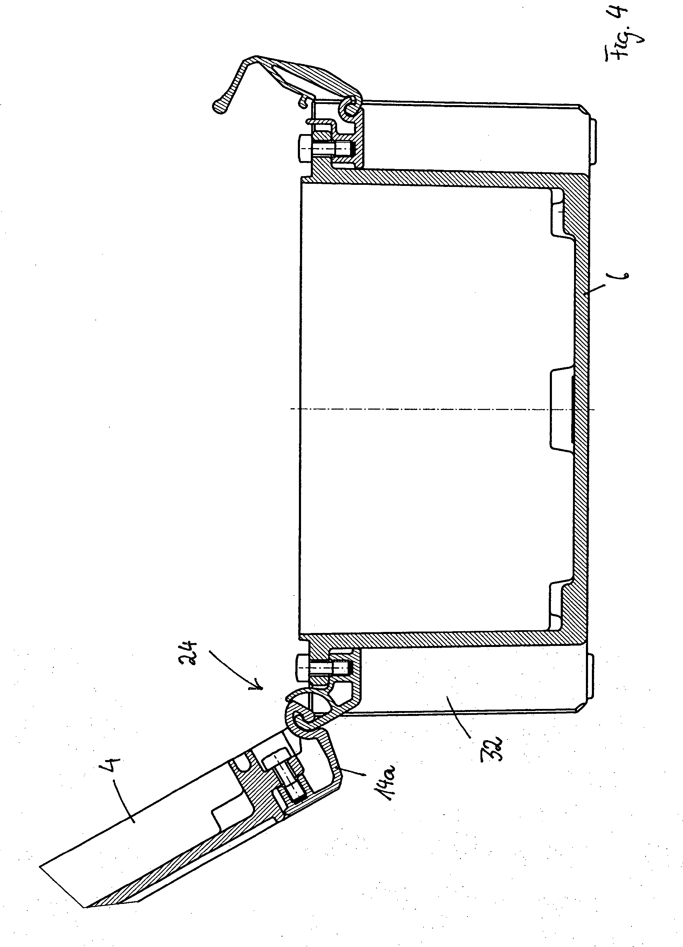

In Fig. 4 ist das Oberteil 4 in einer Offenstellung gezeigt. Auch in der Offenstellung ist das Verbindungsprofil 14a noch gegen ein seitliches Herausschieben durch den Vorsprung 32 gesichert.

Abweichend vom Ausführungsbeispiel muss das Oberteil 4 nicht zwangsläufig gegenüber dem Unterteil 6 verschwenkbar ausgeführt sein. Die Erfindung kann in ihrem Kern auch durch Verbindungsprofile 14 realisiert sein, die auf gegenüberliegenden Stirnseiten fest mit dem Oberteil 4 und dem Unterteil 6 verschraubt sind, wobei dann auf einer Seite zumindest eine Verschraubung von unten her zu erfolgen hat, da das Gehäuse vor der letzten Verschraubung geschlossen werden muss. In diesem Fall sind aber nur die letzten Schrauben, die bevorzugt von unten gesetzt werden, sichtbar.

Vom Ausführungsbeispiel abweichend können auch gegenüberliegende Seiten des Gehäuses 2 mit einem Riegelprofil 22 versehen sein, wodurch es möglich ist, das Oberteil 4 vollständig vom Unterteil 6 abzuheben.

Durch die kreisbogenförmige Führung der Verbindungsprofile 14a, 14b aufeinander im Bereich des Scharniers 24 ergibt sich in der Seitenansicht ein geschlossenes Bild, in dem keine offenen Scharnierteile sichtbar sind.

Das vorstehend beschriebene Ausführungsbeispiel dient nur der Erläuterung der Erfindung. Es bereitet dem Fachmann keine Schwierigkeiten, das Ausführungsbeispiel auf eine ihm als geeignet erscheinende Weise abzuwandeln, um es an einen konkreten Anwendungsfall anzupassen.

## Patentansprüche

1. Gehäuse (2) mit einem Unterteil (6) und einem Oberteil (4), die über eine Schraubverbindung miteinander verbunden sind, wobei die Schraubverbindung so ausgestaltet ist, dass an dem Oberteil (4) auf zumindest einer Seite eine oder mehrere über eine benachbarte Seitenwand (8) nach außen hervorstehende Laschen (10) angeformt sind, die jeweils zumindest ein Schraubloch (12) aufweisen, und das Oberteil (4) über das Schraubloch (12) mit einem Verbindungsprofil (14) verschraubt ist, das an einer dem laschenseitigen Schraubloch (12) entsprechenden Position ebenfalls eine der Verschraubung dienende Einschraubmöglichkeit (16) aufweist, und das Verbindungsprofil (14) das Unterteil (6) mit dem Oberteil (4) verbindet, **dadurch gekennzeichnet, dass** das Verbindungsprofil (14) aus zwei Profilteilen (14a, 14b) zusammengesetzt ist, die durch ein Scharnier (24) miteinander verbunden sind, und das Verbindungsprofil (14) in seiner Montageposition die am Oberteil (4) ausgebildete Lasche (10) oder die dort ausgebildeten Laschen (10) von außen und oben umgreift und im nach außen weisenden Bereich der der Verschraubung dienenden Einschraubmöglichkeit (16) eine geschlossene Oberfläche (18) aufweist, so dass die in das profilseitige Schraubloch (12) eingeschraubte Schraube von unten in das Schraubloch (12) eingeschraubt ist.

2. Gehäuse (2) nach Anspruch 1, **dadurch gekennzeichnet, dass** an dem Oberteil (4) und/oder dem Unterteil (6) im Bereich des Verbindungsprofils (14) seitlich Vorsprünge (32) ausgebildet sind, die das Scharnier in der Einbaulage seitlich abdecken.

3. Gehäuse (2) nach einem der vorhergehenden Ansprüche, **dadurch gekennzeichnet, dass** an dem Unterteil (6) auf zumindest einer Seite eine oder mehrere über eine benachbarte Seitenwand (8) nach außen hervorstehende Laschen (10) angeformt sind, die jeweils zumindest ein Schraubloch (12) aufweisen, und das Unterteil (6) über das Schraubloch (12) mit einem Verbindungsprofil (14) verschraubt ist, das an einer dem laschenseitigen Schraubloch (12) entsprechenden Position ebenfalls eine der Verschraubung dienende Einschraubmöglichkeit (16) aufweist.

4. Gehäuse (2) nach Anspruch 3, **dadurch gekennzeichnet, dass** das Verbindungsprofil (14) in seiner Montageposition die am Unterteil (6) ausgebildete Lasche (10) oder die dort ausgebildeten Laschen (10) von außen und unten umgreift und im nach außen weisenden Bereich der der Verschraubung dienenden Einschraubmöglichkeit (16) eine geschlossene Oberfläche (18) aufweist, so dass die in das profilseitige Schraubloch (12) eingeschraubte Schraube (20) von oben in das Schraubloch (12) eingeschraubt ist.

5. Gehäuse (2) nach einem der vorhergehenden Ansprüche, **dadurch gekennzeichnet, dass** das Verbindungsprofil (14) auf einer Seite des Gehäuses (2) mit einem Scharnier (24) oder einem Schwenkgelenk zur Verschwenkung des Oberteils (4) gegenüber dem Unterteil (6) und das Verbindungsprofil (14) auf der gegenüberliegenden Seite des Gehäuses (2) als ein Riegelprofil (22) ausgebildet ist, das einen über ein Scharnier (24) oder Schwenkgelenk verschwenkbares Riegelteil aufweist.

6. Gehäuse (2) nach Anspruch 5, **dadurch gekennzeichnet, dass** das Riegelteil auf seiner dem Gehäuse (2) zugewandten Innenseite eine Rastnase (26) aufweist, mit der das Verbindungsprofil (14) in einer Schließstellung verrastbar ist.

7. Gehäuse (2) nach Anspruch5 oder 6, **dadurch gekennzeichnet, dass** das Riegelteil an seinem Ende eine Grifflasche (28) oder eine andere Ausgestaltungsform zum Öffnen aufweist.

8. Gehäuse (2) nach einem der vorhergehenden Ansprüche, **dadurch gekennzeichnet, dass** auf der der Lasche oder den Laschen (10) gegenüberliegenden Seite des Oberteils (4) und/oder des Unterteils (6) ein Widerlager (30) zur Verbindung mit dem Verbindungsprofil (14) ausgebildet ist.

9. Gehäuse (2) nach einem der vorhergehenden Ansprüche, **dadurch gekennzeichnet, dass** das Oberteil (4), das Unterteil (6) und die Verbindungsprofile (14) aus einem Metall hergestellt sind.

10. Gehäuse (2) nach einem der vorhergehenden Ansprüche, **dadurch gekennzeichnet, dass** die der Verschraubung dienende Einschraubmöglichkeit (16) als eine sich in Längsrichtung des Verbindungsprofils (14) erstreckende Nut ausgebildet ist, deren Kanalweite ein Untermaß zum Durchmesser der eingesetzten Schraube (20) aufweist.

11. Gehäuse (2) nach einem der vorhergehenden Ansprüche, **dadurch gekennzeichnet, dass** es sich bei den beiden für ein Verbindungsprofil (14) verwendeten Profilteilen um extrudierte, passend abgelängte Profilstücke handelt und die beiden Profilteile im Scharnierbereich so gestaltet sind, dass das erste Profilteil einen Aufnahmeraum (34) mit einer in einem Abschnitt kreisbogenförmig gestalteten Innenoberfläche (36) aufweist, in den das am zweiten Profilteil ausgebildete Scharnierteil (38) eingeschoben ist, wobei das am zweiten Profilteil ausgebildete Scharnierteil eine in einem Abschnitt kreisbogenförmig gestaltete Außenoberfläche (40) aufweist, die spielfrei oder zumindest nahezu spielfrei auf der Innenoberfläche (36) des Aufnahmeraums (34) aufliegt.

12. Gehäuse (2) nach einem der vorhergehenden Ansprüche, **dadurch gekennzeichnet, dass** an dem Unterteil (6) und/oder dem Oberteil (4) Laschen (10) in unterschiedlicher Höhenlage ausgebildet sind.

## Claims

1. Housing (2) comprising a bottom part (6) and a top part (4) which are interconnected by means of a screw connection, the screw connection being designed such that one or more tabs (10), which protrude outwards beyond an adjacent side wall (8), are integrally formed on the top part (4) on at least one side, each of which tabs comprises at least one screw hole (12), and the top part (4) is screwed to a connection profile (14) by means of the screw hole (12), which connection profile also has, at a position corresponding to the tab-side screw hole (12), a way of screwing in (16) that acts as the screw fitting, and the connection profile (14) connects the bottom part (6) to the top part (4), **characterised in that** the connection profile (14) is composed of two profile parts (14a, 14b) that are interconnected by means of a hinge (24), and the connection profile (14), in its assembled position, surrounds the tab (10) formed on the top part (4), or the tabs (10) formed thereon, from outside and above and comprises, in the outwardly pointing region of the way of screwing in (16) that acts as the screw fitting, a sealed surface (18), such that the screw screwed into the profile-side screw hole (12) is screwed into the screw hole (12) from below.

2. Housing (2) according to claim 1, **characterised in that** lateral projections (32) are formed on the top part (4) and/or the bottom part (6) in the region of the connection profile (14), which projections cover the hinge in the installation position.

3. Housing (2) according to either of the preceding claims, **characterised in that** one or more tabs (10) that project outwards beyond an adjacent side wall (8) are integrally formed on the bottom part (6) on at least one side, each of which tabs comprises at least one screw hole (12), and the bottom part (6) is screwed, by means of the screw hole (12), to a connection profile (14) that also comprises, at a position corresponding to the tab-side screw hole (12), a way of screwing in (16) that acts as the screw fitting.

4. Housing (2) according to claim 3, **characterised in that** the connection profile (14), in its assembled position, surrounds the tab (10) formed on the bottom part (6), or the tabs (10) formed thereon, from outside and below and comprises, in the outwardly pointing region of the way of screwing in (16) that acts as the screw fitting, a sealed surface (18), such that the screw (20) screwed into the profile-side screw hole (12) is screwed into the screw hole (12) from above.

5. Housing (2) according to any of the preceding claims, **characterised in that** the connection profile (14) is formed on a side of the housing (2) by means of a hinge (24) or a pivot joint for pivoting the top part (4) with respect to the bottom part (6), and the connection profile (14) is formed on the opposite side of the housing (2) in the form of a catch profile (22) that comprises a catch part which can be pivoted by a hinge (24) or pivot joint.

6. Housing (2) according to claim 5, **characterised in that** the catch part comprises on its inner face facing the housing (2) an engaging lug (26), by means of which the connection profile (14) can be locked in a closed position.

7. Housing (2) according to either claim 5 or claim 6, **characterised in that** the catch part comprises on its end a grip tab (28) or a different type of configuration for opening.

8. Housing (2) according to any of the preceding claims, **characterised in that** an abutment (30) for connection to the connection profile (14) is formed on the side of the top part (4), and/or the bottom part (6), that is opposite the tab or the tabs (10).

9. Housing (2) according to any of the preceding claims, **characterised in that** the top part (4), the bottom part (6) and the connection profiles (14) are made of a metal.

10. Housing (2) according to any of the preceding claims, **characterised in that** the way of screwing in (16) that acts as the screw fitting is formed as a groove extending in the longitudinal direction of the connection profile (14), the channel of which groove has a width that is undersized with respect to the diameter of the inserted screw (20).

11. Housing (2) according to any of the preceding claims, **characterised in that** the two profile parts used for a connection profile (14) are extruded, cut-to-fit profile pieces, and the two profile parts are formed in the hinge region such that the first profile part comprises a receiving space (34) having an inner surface (36) that is in the shape of an arc of a circle in one portion, into which receiving space the hinge part (38), formed on the second profile part, is pushed, the hinge part formed on the second profile part comprising an outer surface (40) that is in the shape of an arc of a circle in one portion and rests against the inner surface (36) of the receiving space (34) in a clearance-free, or at least virtually clearance-free, manner.

12. Housing (2) according to any of the preceding claims, **characterised in that** tabs (10) are formed at various levels on the bottom part (6) and/or on the top part (4).

## Revendications

1. Boîtier (2) comprenant une partie inférieure (6) et une partie supérieure (4) qui sont reliées entre elles par une liaison à vis, la liaison à vis étant conçue de telle sorte qu'une ou plusieurs attaches (10), saillant d'une paroi latérale adjacente (8) vers l'extérieur, sont formées sur la partie supérieure (4), sur au moins un côté, lesquelles attaches comportent chacune au moins un trou fileté (12) et la partie supérieure (4) est vissée par l'intermédiaire du trou fileté (12) à un profilé de liaison (14) qui comporte à une position correspondant au trou fileté côté attache (12) également un moyen fileté (16) servant au vissage et le profilé de liaison (14) relie la partie inférieure (6) à la partie supérieure (4), **caractérisé en ce que** le profilé de liaison (14) se compose de deux parties profilées (14a, 14b) qui sont reliées entre elles par une charnière (24) et **en ce que** le profilé de liaison (14) enserre depuis l'extérieur et le haut, dans sa position de montage, l'attache (10) formée sur la partie supérieure (4) ou les attaches (10) formées à cet endroit et possède une surface fermée (18) dans la région, tournée vers l'extérieur, du moyen fileté (16) servant au vissage de sorte que la vis, vissée dans le trou fileté côté profilé (12), est vissée depuis le bas dans le trou fileté (12).

2. Boîtier (2) selon la revendication 1, **caractérisé en ce que** des saillies (32) sont formées latéralement sur la partie supérieure (4) et/ou la partie inférieure (6) dans la région du profilé de liaison (14), lesquelles saillies recouvrent latéralement la charnière dans la position de montage.

3. Boîtier (2) selon l'une des revendications précédentes, **caractérisé en ce qu'**une ou plusieurs attaches (10), saillant vers l'extérieur d'une paroi latérale adjacente (8), sont formées sur la partie inférieure (6), sur au moins un côté, lesquelles attaches comportent chacune au moins un trou fileté (12) et **en ce que** la partie inférieure (6) est vissée via le trou fileté (12) à un profil de liaison (14) qui comporte, à une position correspondant au trou fileté côté attache (12), également un moyen fileté (16) servant au vissage.

4. Boîtier (2) selon la revendication 3, **caractérisé en ce que** le profilé de liaison (14) enserre depuis l'extérieur et le bas, dans sa position de montage, l'attache (10) formée sur la partie inférieure (6) ou les attaches (10) formées à cet endroit et possède une surface fermée (18) dans la région, tournée vers l'extérieur, du moyen fileté (16) servant au vissage de sorte que la vis (20), vissée dans le trou fileté côté profilé (12), est vissée depuis le haut dans le trou fileté (12).

5. Boîtier (2) selon l'une des revendications précédentes, **caractérisé en ce que** le profilé de liaison (14) est conformé, sur un côté du boîtier (2), avec une charnière (24) ou une articulation à pivot destinée à faire pivoter la partie supérieure (4) par rapport à la partie inférieure (6) et **en ce que** le profilé de liaison est conformé, du côté opposé du boîtier (2), en profilé de verrouillage qui comporte un élément de verrouillage pouvant pivoter par le biais de la charnière ou de l'articulation à pivot.

6. Boîtier (2) selon la revendication 5, **caractérisé en ce que** l'élément de verrouillage comporte, sur son côté intérieur tourné vers le boîtier (2), un ergot d'encliquetage (26) au moyen duquel le profil de liaison (14) peut être encliqueté dans une position fermée.

7. Boîtier (2) selon la revendication 5 ou 6, **caractérisé en ce que** l'élément de verrouillage comporte à son extrémité une attache de préhension (28) ou un autre mode de réalisation destiné à l'ouverture.

8. Boîtier (2) selon l'une des revendications précédentes, **caractérisé en ce qu'**une butée (30) destinée à être raccordée au profil de liaison (14) est formée du côté, opposé à l'attache ou aux attaches (10), de la partie supérieure (4) et/ou de la partie inférieure (6).

9. Boîtier (2) selon l'une des revendications précédentes, **caractérisé en ce que** la partie supérieure (4), la partie inférieure (6) et les profilés de liaison (14) sont réalisés en métal.

10. Boîtier (2) selon l'une des revendications précédentes, **caractérisé en ce que** le moyen fileté (16) servant au vissage est conformé en rainure qui s'étende dans la direction longitudinale du profilé de liaison (14) et dont la largeur de gorge a une dimension inférieure au diamètre de la vis insérée (20).

11. Boîtier (2) selon l'une des revendications précédentes, **caractérisé en ce que** les deux parties profilées utilisées pour un profil de liaison (14) sont des pièces profilées extrudées de longueur adaptée et **en ce que** les deux parties profilées sont configurées dans la région de charnière de telle sorte que la première partie profilée comporte un espace de réception (34) qui possède une surface intérieure (36), dont une portion est conformée en arc de cercle, et dans lequel est inséré l'élément de charnière (38) formé sur la seconde partie profilée, l'élément de charnière formé sur la seconde partie profilée possédant une surface extérieure (40) dont une portion est conformée en arc de cercle et qui repose sans jeu ou au moins presque sans jeu sur la surface intérieure (36) de l'espace de réception (34).

12. Boîtier (2) selon l'une des revendications précédentes, **caractérisé en ce que** des attaches (4) (10) sont formées à des hauteurs différentes sur la partie inférieure (6) et/ou la partie supérieure.
